# EUROPEAN PATENT APPLICATION

(11) **EP 0 660 401 A2**
(43) Date of publication of application: **28.06.1995**
(21) Application number: 94120262.4
(22) Date of filing: 21.12.1994
(51) Int. Cl.: H01L 23/433

(54) **Resin-encapsulated semiconductor device**

(30) Priority: 24.12.1993 JP 328401/93
(71) Applicant: KABUSHIKI KAISHA TOSHIBA, Kawasaki-shi, Kanagawa-ken 210 (JP)
(72) Inventor: Sasaki, Akira, c/o Intel. Prop. Div., K.K. Toshiba, Tokyo 105 (JP)
(74) Representative: Lehn, Werner, Dipl.-Ing.

(57) **Abstract**

A semiconductor chip (15) is mounted on a heat-radiating fin (11). A ceramic plate (14) is mounted on the fin (11), surrounding the semiconductor chip (15). A copper pattern is provided on the ceramic plate. A real frame (12) is connected to the copper pattern, located above the heat-radiating fin (11) and spaced apart therefrom by a predetermined distance. The copper pattern and the semiconductor chip (15) are connected by means of wires (17). The wires (17), the chip (15), the ceramic plate (14) and a part of the lead frame (12) are encapsulated in a mass of resin.

## Description

The present invention relates to a resin-encapsulated semiconductor device, and more particularly to a resin-encapsulated semiconductor device which is free of short-circuiting between the lead frame and the heat-radiating fin or short-circuiting among the wires connecting the lead frame to the semiconductor chip.

There is the trend that IC and LSI packages have more and more pins. The same is true of IC or LSI packages of the type which has a heat-radiating fin. In the market of semiconductor devices, there is the demand for an IC or LSI package which has an increased number of pins and which yet has a smaller size.

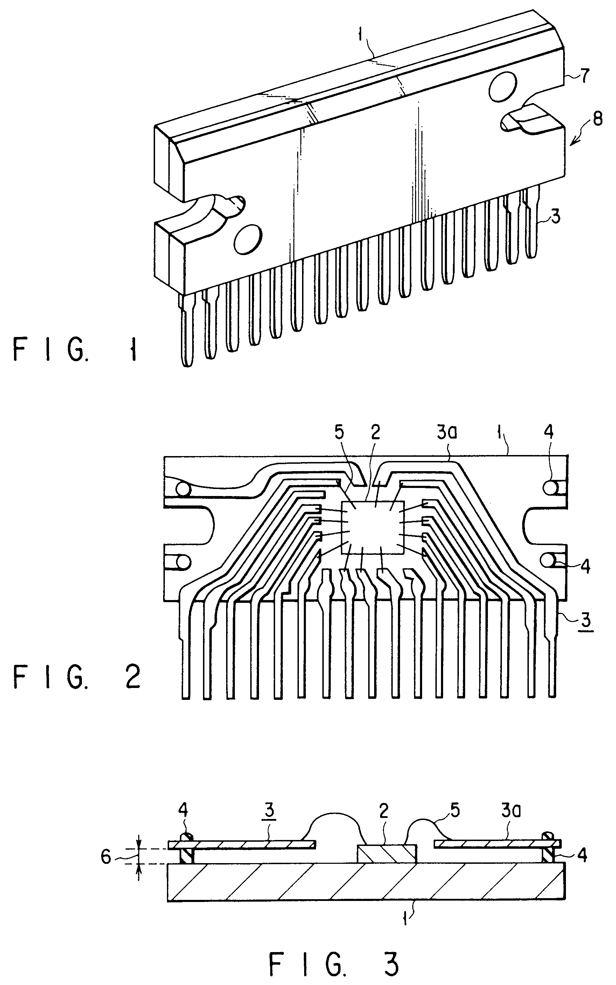

FIG. 1 is a perspective view of a conventional resin-encapsulated semiconductor device. FIG. 2 is a plan view showing the internal structure of the device. FIG. 3 is a side view of the internal structure shown in FIG. 2. With reference to FIGS. 1, 2 and 3, it will be explained how the device is manufactured in the form of a semiconductor package.

First, as shown in FIGS. 2 and 3, a semiconductor chip 2 is mounted on a heat-radiating fin 1. A lead frame 3 is attached to the heat-radiating fin 1 by means of caulking. More precisely, the four corners of the lead frame 3 are fastened to the heat-radiating fin 1 by four caulking members 4 which protrude from the four corners of the fin 1. A gap 6 is thereby provided between the heat-radiating fin 1 and the lead frame 3. By virtue of the gap 6, the lead frame 3 is electrically insulated from the heat-radiating fin 1. Then, the inner leads of the frame 3 are connected by wires 5 to the semiconductor chip 2. Thereafter, as shown in FIG. 1, the semiconductor chip 2, a part of the lead frame 3, and the wires 5 are sealed in a resin mass 7. As a result, a semiconductor package 8 is manufactured.

To use more pins in the conventional semiconductor package 8 and also to make the package 8 of the device smaller, it is necessary to pattern the lead frame 3 more finely. If the lead frame 3 is so patterned, each lead will be very slender. The more slender the leads, the greater the likelihood of short-circuiting between the lead frame 3 and the heat-radiating fin 1. When molten resin is poured onto the semiconductor chip 2, the wire 5 and that part of the lead frame 3 which are located above the fin 1, it applies a pressure on the wires 5 and said part of the lead frame 3. Made slender, the leads may be bent downwards under the pressure, inevitably contacting the head-radiating fin 1.

Furthermore, in order to use more pins in the conventional semiconductor package 8, it is necessary to increase the distance between the semiconductor chip 2 and the tip of each inner lead 3a. The longer the distance, the longer the wires 5 must be. The longer the wires 5, the greater the possibility that the wires 5 are bent to contact one another, due to the pressure which the molten resin exerts on them as it is poured onto the chip 2, the wire 5 and said part of the lead frame 3.

The object of the present invention is to provide a resin-encapsulated semiconductor device which is made in the form of a small package having many pins and which is yet free of short-circuiting between the lead frame and the heat-radiating fin or among the wires connecting the lead frame to the semiconductor chip.

To attain the object, according to the invention there is provided a resin-encapsulated semiconductor device which comprises: a semiconductor chip; a heat-radiating fin for radiating heat generated by the semi-conductor chip; an insulating member mounted on the heat-radiating fin; a wiring pattern formed on the insulating member; a lead frame connected to the wiring pattern, located above the heat-radiating fin and electrically insulated from the heat-radiating fin; and a mass of resin encapsulating the semiconductor chip, the insulating member and a part of the read frame.

In the device, the lead frame is connected to the wiring pattern formed on the insulating member which is mounted on the heat-radiating fin. Since the wiring pattern is used, the lead frame can be made shorter than otherwise. Even if patterned finely, the lead frame is hardly deformed, despite the pressure applied to it when molten resin is poured onto the semiconductor chip, the wiring pattern and the part of the lead frame. As a result, short-circuiting occurs neither between the lead frame and the heat-radiating fin nor among the wires connecting the lead frame to the semiconductor chip.

This invention can be more fully understood from the following detailed description when taken in conjunction with the accompanying drawings, in which:
FIG. 1 is a perspective view of a conventional resin-encapsulated semiconductor device;
FIG. 2 is a plan view showing the internal structure of the conventional semiconductor device;
FIG. 3 is a side view of the internal structure shown in FIG. 2;
FIG. 4 is a perspective view of a resin-encapsulated semiconductor device according to the present invention;
FIG. 5 is a plan view showing the internal structure of the semiconductor device shown in FIG. 4;
FIG. 6 is a side view of the internal structure illustrated in FIG. 4; and
FIG. 7 is a diagram for explaining the method of manufacturing the semiconductor device shown in FIG. 4.

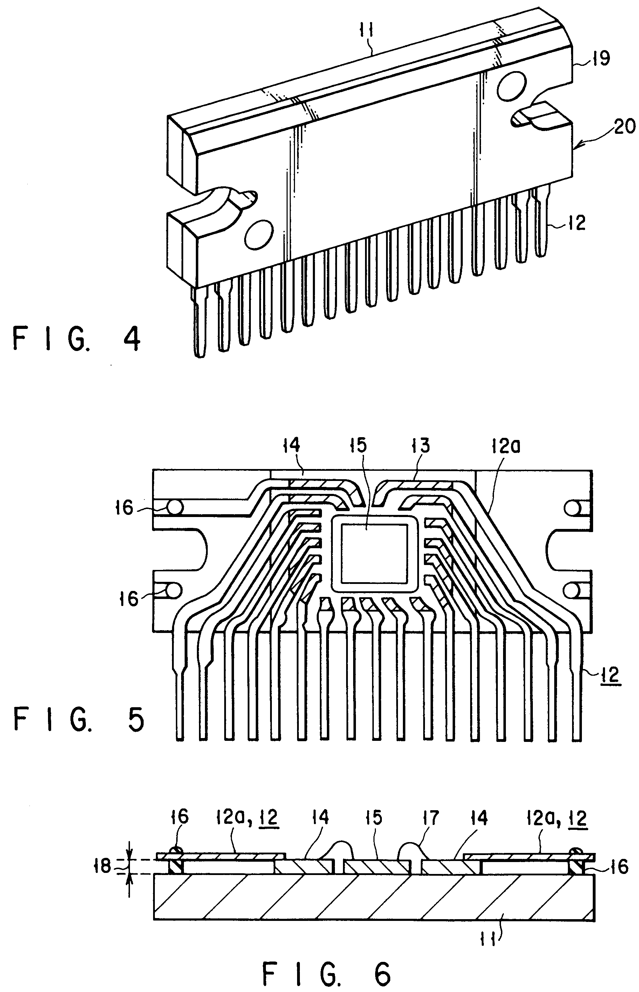

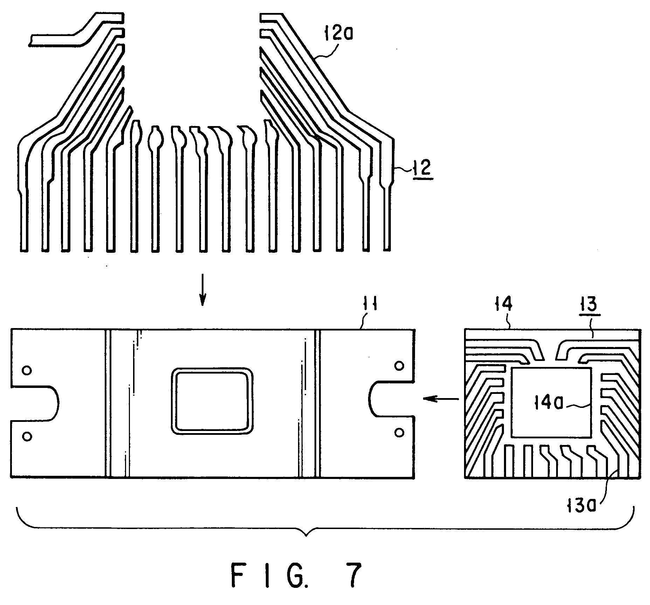

A resin-encapsulated semiconductor device according to the invention will now be described, with reference to FIGS. 4 to 7. FIGS. 4, 5 and 6 are a perspective view, a plan view and a side view, respectively. FIG. 7 is a diagram explaining the method of manufacturing the device.

As shown in FIG. 7, the the resin-encapsulated semiconductor device comprises a heat-radiating fin 11, a lead frame 12, and a ceramic plate 14. The plate 14 is made of, for example, Al₂O₃ and has a copper pattern 13 formed on the upper surface. The plate 14 has a rectangular hole 14a in its center portion. It is in this hole 14a that a semiconductor chip (not shown) will be located. The copper pattern 13 consists of a plurality of copper strips 13a. The copper strips 13a are so arranged that one end of each is located at one side of the plate and the other end of each located near the rectangular hole 14a.

The method of manufacturing the device in the form of a semiconductor package will be explained, with reference to FIGS. 4, 5, 6 and 7.

First, the ceramic plate 14 having the copper pattern 13 on it is mounted on the center portion of the heat-radiating fin 11 shown in FIG. 7. The semiconductor chip 15 is then mounted on that portion of the fin 11 which is exposed through the hole 14a of the ceramic plate 14. Next, the four corners of the lead frame 12 are fastened to the heat-radiating fin 11 by four caulking members 16 which protrude from the four corners of the fin 11. A gap 18 is thereby provided between the heat-radiating fin 11 and the lead frame 12. By virtue of the gap 18, the lead frame 12 is electrically insulated from the heat-radiating fin 11.

Then, the inner leads 12a of the frame 12 are connected at one end to the copper pattern 13. More precisely, each inner lead 12a is directly connected to one end of the corresponding copper strip 13a. Next, the copper strips 13a are connected at the other end to the semiconductor chip 15 by wires 17 made of gold (Au).

Thereafter, as shown in FIG. 4, the semiconductor chip 15, the wires 17, the inner leads 12a and the ceramic plate 14, and the wires 17 are sealed in a resin mass 19. As a result, a semiconductor package 20 is manufactured.

As indicated above, the ceramic plate 14 with the copper strips 13a formed on it is mounted on the center portion of the heat-radiating fin 11, and the tips of the inner leads 12a are directly connected to the copper strips 13a. The inner leads 12a, namely those portions of the lead frame 12 which are sealed in the resin mass 19, are shorter than the inner leads of the frame 3 used in the conventional semiconductor package 8 (FIG. 1). Therefore, even if the lead frame 12 is patterned finely to increase the number of pins and to make the package 20 small, the lead frame 12 is hardly deformed, despite the pressure applied to it when molten resin 19 is poured onto the semiconductor chip 15, the wires 17, the inner leads 12a and the ceramic plat 14. It follows that no short-circuiting occurs between the lead frame 12 and the heat-radiating fin 11.

As described above, the ceramic plate 14 is mounted on the upper surface of the heat-radiating fin 11, and the copper strips 13a formed on the plate 14 are connected at the other end to the semiconductor chip 15 by the wires 17. The wires 17 are therefore shorter than the wires 5 used in the conventional semiconductor package 8 (FIG. 1). The wires 17 are less likely to be bent due to the pressure which the molten resin 19 exerts on them as it is poured onto them. Thus, even if the wires 17 are spaced by by a short distance because of the small size and many pins the package 20 has, the wires 17 are not bent so much to cause short-circuiting among them.

Since short-circuiting occurs neither between the lead frame 12 and the heat-radiating fin 11, nor among the wires 17 connecting the lead frame 12 to the semi-conductor chip 15, the semiconductor package 20 has high quality and high reliability. The package 20 can, therefore, be incorporated into CAR products which are required to operate with high reliability.

Unlike the conventional semiconductor package 8 shown in FIG. 1, the package 20 need not be put to various tests for its reliability, such as X-ray test for determining whether or not the lead frame 12 is sufficiently spaced apart from the heat-radiating fin 11, nor is it necessary to control the warping of the heat-radiating fin 11 to ensure the reliability required of the semiconductor package 20. This is because, as mentioned above, no short-circuiting occurs between the lead frame 12 and the heat-radiating fin 11 or among the wires 17 connecting the lead frame 12 to the semiconductor chip 15, even if the package 20 is small and has many pins. Hence, the manufacturing process of the package 20 can be easily controlled, reducing the cost of the package 20.

The present invention can be applied to large-size semiconductor chips, thereby to manufacture greatly value-added products.

In the embodiment described above, the ceramic plate 14 is mounted on the center portion of the heat-radiating fin 11. Nonetheless, the ceramic plate 14 may be replaced by another type of an insulating member which is placed on the center part of the fin 11.

Furthermore, the copper pattern 13 may be replaced by a wiring pattern made of any material other than copper, which is formed on the upper surface of the ceramic plate 14.

## Claims

1. A resin-encapsulated semiconductor device characterized by comprising:
a semiconductor chip (15);
a heat-radiating fin (11) for radiating heat generated by said semiconductor chip (15);
an insulating member (14) mounted on said heat-radiating fin (11);
a wiring pattern (13) formed on said insulating member (14);
a lead frame (12) connected to said wiring pattern (13), located above said heat-radiating fin (11) and electrically insulated from said heat-radiating fin (11); and
a mass of resin (19) encapsulating said semiconductor chip (15), said insulating member (14) and a part of said read frame (12).

2. The device according to claim 1, characterized in that said insulating member (14) is a ceramic plate.

3. The device according to claim 1, characterized in that said wiring pattern (13) is a copper pattern.

4. A resin-encapsulated semiconductor device characterized by comprising:
a heat-radiating fin (11);
a semiconductor chip (15) mounted on said heat-radiating fin (11);
an insulating member (14) mounted on said heat-radiating fin (11) and surrounding said semiconductor chip (15);
a wiring pattern (13) formed on said insulating member (14);
a lead frame (12) connected to said wiring pattern (13), located above said heat-radiating fin (11) and spaced apart from said heat-radiating fin (11) by a predetermined distance;
wires (17) connecting said wiring pattern (13) to said semiconductor chip (15); and
a mass of resin (19) encapsulating said wires (17), said semiconductor chip (15), said insulating member (14) and a part of said read frame (12).

5. The device according to claim 4, characterized in that said insulating member (14) is a ceramic plate.

6. The device according to claim 4, characterized in that said wiring pattern (13) is a copper pattern.

7. A resin-encapsulated semiconductor device characterized by comprising:
a heat-radiating fin (11);
an insulating member (14) mounted on said heat-radiating fin (11) and having a hole (14a);
a semiconductor chip (15) mounted on said heat-radiating fin (11) and located in the hold (14a) of said insulating member (14);
a wiring pattern (13) formed on said insulating member (14);
a lead frame (12) connected to said wiring pattern (13), located above said heat-radiating fin (11) and spaced apart from said heat-radiating fin (11) by a predetermined distance;
wires (17) connecting said wiring pattern (13) to said semiconductor chip (15); and
a mass of resin (19) encapsulating said wires (17), said semiconductor chip (15), said insulating member (14) and a part of said read frame (12).

8. The device according to claim 7, characterized in that said wiring pattern (13) is comprised of a plurality of wiring strips (13), each having one end located at an edge of said insulating member (14) and another end located near the hole (14a) of said insulating member (14).

9. The device according to claim 8, characterized in that said insulating member (14) is a ceramic plate.

10. The device according to claim 8, characterized in that said wiring pattern (13) is a copper pattern.
